# EUROPEAN PATENT SPECIFICATION

(11) **EP 0 330 301 B1**
(45) Date of publication and mention of the grant of the patent: **04.08.1993**
(21) Application number: 89300355.8
(22) Date of filing: 16.01.1989
(51) Int. Cl.: H05K 13/04

(54) **Manufacturing apparatus for positioning and monitoring semiconductor components**
Maschine zur Positionierung und Kontrolle von Halbleiterelementen
Machine pour positionner et contrôler des composants semi-conducteurs

(30) Priority: 16.02.1988 US 155945
(43) Date of publication of application: 30.08.1989
(73) Proprietor: International Business Machines Corporation, Armonk, N.Y. 10504 (US)
(72) Inventor: Hunt, Ronald Eugene, Georgetown Texas 78628 (US); Whitehead, Verlon Eugene, Austin Texas 78759 (US)
(74) Representative: Burt, Roger James, Dr.

(56) References cited:
- EP-A- 0 081 242
- DE-A- 3 638 025
- DE-B- 1 258 935
- FR-A- 2 515 918
- US-A- 4 070 753

## Description

This invention relates to a manufacturing apparatus for automatically placing electronic components on circuit boards, and, more particularly, to an apparatus for sequentially positioning chip components adjacent corresponding sites on the board for subsequent placement thereon.

Due to many factors including the high cost of labour associated with populating circuit boards with components, technology in the electronic manufacturing arts has development to automatically place such components on boards. A representative system is seen depicted in US-A-4,202,092. Tapes or magazines carry a plurality of components each of which is sequentially withdrawn from the tape or magazine. The pins thereof are then automatically inserted in corresponding holes in the board by means of a relatively complex mechanical robot arm linkage associated with each component type. Such systems are deficient in many respects. First, mechanisms were required to sever each component from the tape and bend leads for registration in the holes. Moreover, a complex mechanical linkage was required for each such component type as well as a corresponding relatively long travel path of the component from the tape or magazine to the location on the board. However, due to relatively small component densities, pin-in-hole tolerances initially in the development of the art were not so critical as to require more precise component placement.

Yet another example of the aforementioned art may be seen in US-A- 4,543,713 wherein there is disclosed yet another automated technique for installing components on a circuit board. A magazine containing a plurality of the leaded components is provided. In like manner to the hereinbefore noted reference, a relatively complex and large mechanical system is required for sequentially placing the components on the board. The system is primarily applicable to relatively large leaded components. Moreover due to the aforementioned relative complexity of the mechanical system involved, the number of systems and thus components which may be simultaneously placed on a single board is accordingly limited.

In US-A- 4,222,166 disclosed therein is a system which seeks to alleviate some of the aforementioned problems. A plurality of pinned components are positioned proximate their appropriate positions on the board for subsequent manual insertion. A somewhat less complex mechanism is thereby provided so as to facilitate positioning of the components. The system nevertheless requires a manual step. Each component is sequentially withdrawn from its correlative magazine followed by manual insertion of the leads thereof in corresponding holes disposed through the board. Moreover, notwithstanding simplification of the mechanical system relative to the previously described references, the mechanisms were nevertheless still relatively complex and bulky.

In US-A- 4,528,747, a system is disclosed wherein sequential manual insertion of pins is sought to be avoided. A template is provided having a plurality of apertures for matingly receiving a corresponding plurality of desired components, although the reference provides little information as to how these components are loaded from corresponding magazines into the apertures. The template carrying the components is thence positioned over the circuit board by a robotic arm. By means of vibration, the pins of the various components are disposed through the appropriate holes. Not only does such a system require again a relatively complex mechanical system in the form of a robotic arm to position the components adjacent the desired sites on the circuit boards, but no details are disclosed for conveying the components from their respective magazines to their apertures in the template.

US-A- 4,300,715 reflects a move in the art to leadless components to avoid the aforementioned problems in placement of pinned or leaded components through circuit board holes. Component chips disposed on tape such as that used in the prior references to carry leaded components are removed from the tape sequentially by a complex robot gripper mechanism and deposited at the desired location on a substrate. In US-A- 4,342,090 there is disclosed a system for simultaneously positioning a plurality of chips onto corresponding sites. The chips are simultaneously withdrawn from their corresponding magazines and transported by means of a vacuum pencil pickup assembly travelling upwards, laterally, and thence downwards so as to deposit the chips on their respective sites.

In US-A- 4,451,324, yet another system is disclosed for depositing a plurality of chip type circuit elements on a board. A plurality of pipes are provided each of which extends to a supply of circuit components. The components travel through their respective supplies in an end-on-end fashion until they are deposited by the pipes at corresponding desired preselected locations on the circuit board. Elaborate boots and shuttle plate means are provided for thence rotating the components into horizontal alignment at desired orientations on a template whereupon the template thence deposits the various components simultaneously on the board in the desired alignment. There is no detailed disclosure of the means by which the components associated with each tube are individually disposed within each tube from the corresponding component supplies. Although a system is nevertheless disclosed for simultaneous chip placement, once again the mechanism in its entirety for positioning a plurality of chips adjacent corresponding circuit board sites is quite complex.

In a move to simplify the simultaneous positioning of chips adjacent correlative sites of a circuit board, a system is provided by Panasonic National, details of a representative system thereof being set forth in a publication entitled "Specifications: Panasert Simultaneous Chip Component Placement Machine Model No. NM-8270". With regard to such disclosure and specifically with respect to the details thereof set forth on page 8, a plurality of sticks each carrying stacked chip components therein may be loaded directly onto corresponding placement stations within the machine. The circuit board to be populated is thence positioned over the plurality of competent sticks. The sticks are arranged in a horizontal pattern corresponding to the horizontal pattern of sites on the underneath side of the board at which the components are desirably to be placed. The underneath side of the board is coated with an adhesive. Upon upward urging of the stacks of components within their corresponding sticks by means of pushing pins or the like, the topmost components of the sticks are thereby urged against the adhesive on the board at the corresponding locations thereon where the components are desired to be placed. The thus-populated board is then replaced with the next board and the process repeated, resulting in simultaneous multiple chip component placement.

While the aforementioned system does eliminate problems associated with robotic arms, relatively complex travel paths of the circuit components from the magazines or tapes to the circuit board sites, and the like, several serious problems are nevertheless associated with this system. Notable among these are the tendency which components have to stick together when withdrawn vertically from the sticks caused by static, dust, dirt, adhesive or other particulate matter present on the components and adjacent thereto. Problems associated with this failure of components to uniformly exit the stick and be deposited on the board include jamming of the system and incorrect orientation of the uppermost chips in the stick after deposition on the board in undesired orientations (as, for example, when the chip may be turned so as to rest vertically on its edge rather than presenting a substantially horizontal planar surface to be impressed into the adhesive coating). This, in turn results, in unacceptable rejection rates for the populated boards.

European Patent Application EP-A2-081 242 discloses an apparatus for equipping circuit boards with flat electronic components as set out in the precharacterising portion of claim 1. The components are stacked in magazines. A sliding plate with holes therein is drivable so as to collect components in the holes and move the components under suction tubes. These suction tubes hold the components while a second plate with apertures therein aligns itself with the sliding plate such that the apertures are aligned with the holes in the sliding plate. Then the suction tubes pass downwards through the holes and apertures to bring the components into contact with an underlying circuit board.

It is desired to provide a chip positioning apparatus adapted for simultaneous multi-component placement, which is of a small, simple, inexpensive and reliable construction for populating high circuit density boards. Such apparatus was further desired which also facilitated rapid off-line replenishment of chip supplies and ease of varying chip placement patterns to accommodate different product circuit boards and to minimise placement machine downtime.

Accordingly the present invention provides manufacturing apparatus for positioning and mounting semiconductor chip circuit devices at and on circuit board sites comprising:
supporting means for supporting a stack of chips adjacent a circuit board, defining a longitudinal axis therethrough, and including a magazine for receiving the stack of chips and a mounting block carrying the magazine;
stripping means for urging a first chip from a first position adjacent to the stack along a line substantially transverse to the stack into a cavity, and into a second position adjacent one of the circuit board sites; and
a vacuum tube in which a pressure differential is created for supporting the first chip against an end of the tube (36) while maintaining alignment with the circuit board site by means of the cavity, characterised in that:
the cavity is defined by surfaces of the mounting block; and
the stripping mean returns to the first position to accept a second chip whilst the first chip is supported by the tube.

In one embodiment apparatus for positioning electronic components, such as surface-mounted chips, for subsequent placement on a circuit board comprises support means disposing a plurality of such components in a stack adjacent the board. Stripping means in slidable engagement with the support means sequentially urges each chip in the stack transversely of the stack from a first position therein to a second position opposing a corresponding desired site on the board where the chip is to be placed.

The support means includes a mounting block having connector means for releasable interconnection of the positioning apparatus to a top plate. Chamber means maintains the chip at the second position in response to fluid pressure differential. The support means is further adapted to receive a chip placement means for transporting the chip from the second position to a third position wherein it engages the board site. Means are provided which in one embodiment take the form of tapering sidewall guides for adjusting orientation of the chip during movement from the first to the second position to insure proper alignment on the site. In one embodiment, the chip placement means is a vertical hollow tube movable vertically between a location within a funnel-shaped aperture and connecting lower vertical cylindrically shaped second tube aperture, and a location adjacent the chip site. Vacuum drawn in the tube while the chip moves into the second position and while the tube is in a first position within the first and second apertures causes the chip to be releasably suspended from the lower end of the tube while the stripping means returns to a first position to strip off a next chip from the stack. The tube then lowers vertically downward toward the chip site carrying the suspended chip downward through the support block and impressing it on the site, whereupon vacuum is discontinued. The chip is thereby deposited on the site as desired.

In order that the invention may be fully understood a preferred embodiment will now be described with reference to the accompanying drawings in which:
Fig. 1 is a pictorial view, partly in section, of the apparatus of the present invention.
Fig. 2 is a pictorial view of the slider portion of the apparatus of Fig. 1.
Fig. 3 is a pictorial view of the apparatus of the present invention in section taken along line 1-1 of Fig. 1.
Fig. 4 is a reverse side view of the apparatus of Fig. 1 in section taken along line 1-1.
Figs. 5-9 are pictorial views, partly in section taken along line 1-1, of the apparatus of Fig. 1 taken at respective first, second, third, fourth and fifth operational stages.
Figs. 10-12 are side views, in section taken along line 1-1, of the apparatus of Fig. 1 in a mounted position depicting sequential operation of the slide locking feature
Fig. 13 is an enlarged simplified side view, partly in section taken along line 1-1, of a portion of the stripper, chips, and mounting block of the apparatus in Fig. 1 depicting in more detail relative dimensional relationships thereof.
Fig. 14 is a simplified top view in section taken along line 2-2 of a part of the apparatus depicted in Fig. 2 illustrating the guide surfaces 121, 123.
Fig. 15 is another simplified top view in section taken along line 2-2 of a part of the apparatus depicted in Fig. 2 illustrating the guide surfaces 121, 123.
Fig. 16 is a side view, partly in section depicting the apparatus of the present invention in a locked position.
Fig. 17 is a pictorial view depicting the bottom of the apparatus illustrated in Fig. 1.

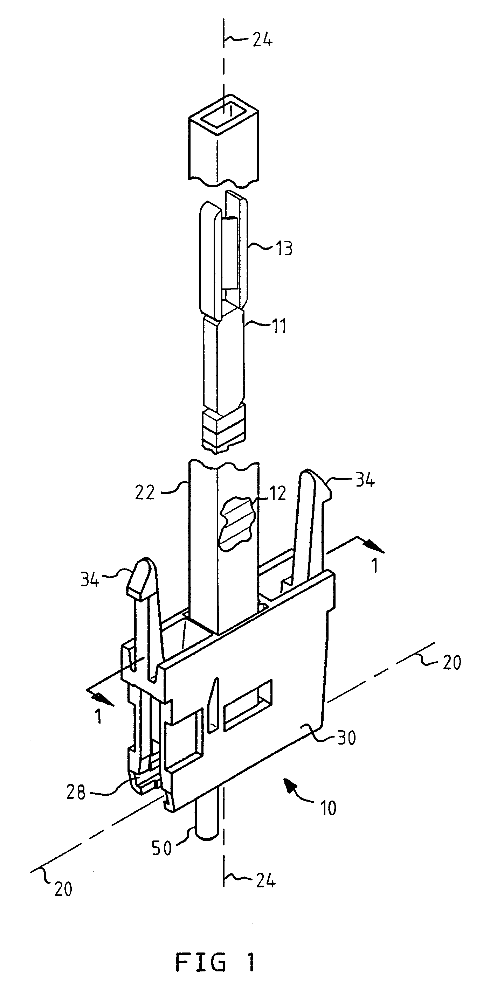

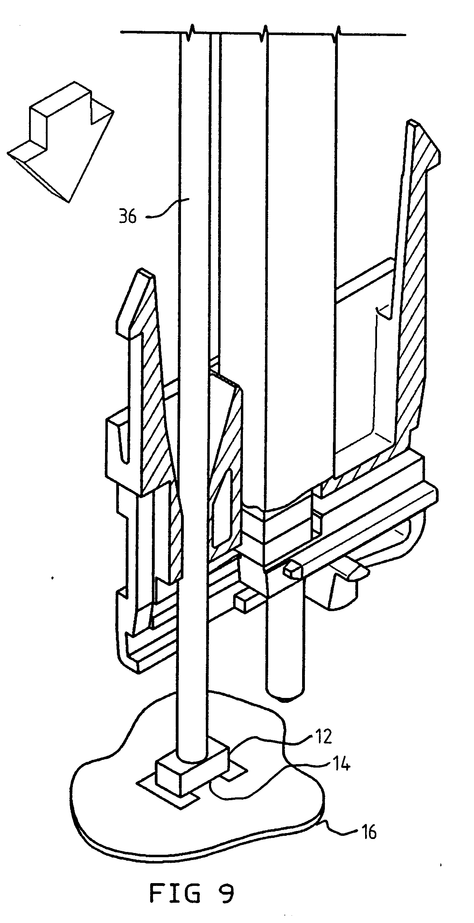

Referring first to Fig. 1, there is shown apparatus 10 for sequentially positioning electronic components such as surface mounted chips 12 for mounting at respective sites 14, Fig. 9, on a circuit board 16, Fig. 9.

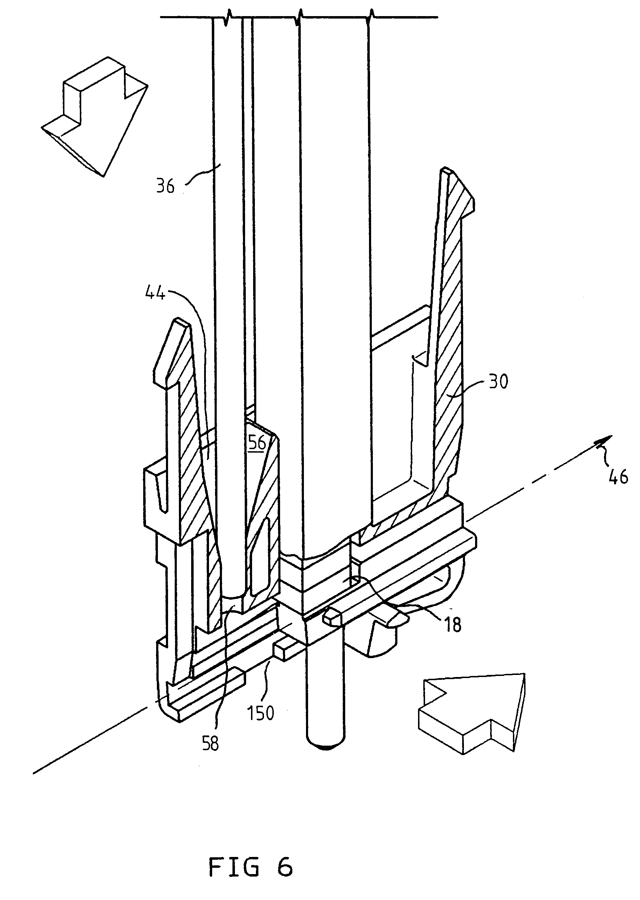

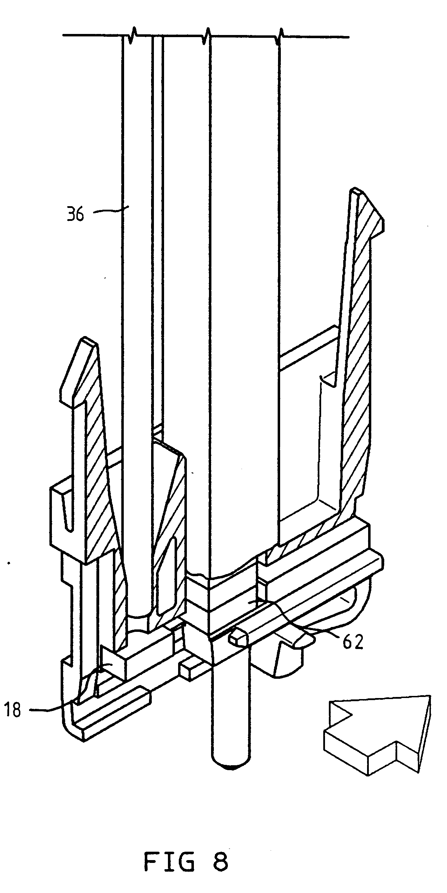

The apparatus 10 is basically comprised of support means for supporting a stack of the components 12 adjacent the board 16, and stripping means for urging the first chip 18 of the stack, Fig. 6, along a line 20 extending generally transversely of the stack. The stripping means is provided to urge each of the chips 12 along the line 20 from a first position within the stack, Fig. 6, to a second position, Fig. 8, opposing a corresponding site on a circuit board, prior to the chip 18 being mounted on the site 14 as shown in Fig. 9.

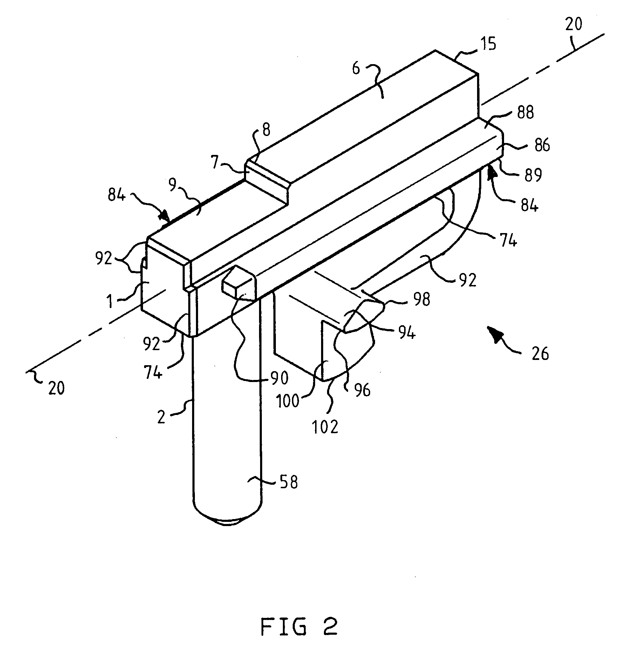

The support means may take the form of a magazine 22, Fig. 1 receiving a plurality of the chips 12 arranged in a stack therewithin defining a longitudinal axis 24. A press-fit stopper 13 is provided to prevent spillage of components out the end of magazine 22. A weight 11 assists downward gravity feed of components. The stripping means may preferably take the form of a slider 26, Fig. 2, in slidable engagement with mating cavities 28 extending internally of a mounting block 30.

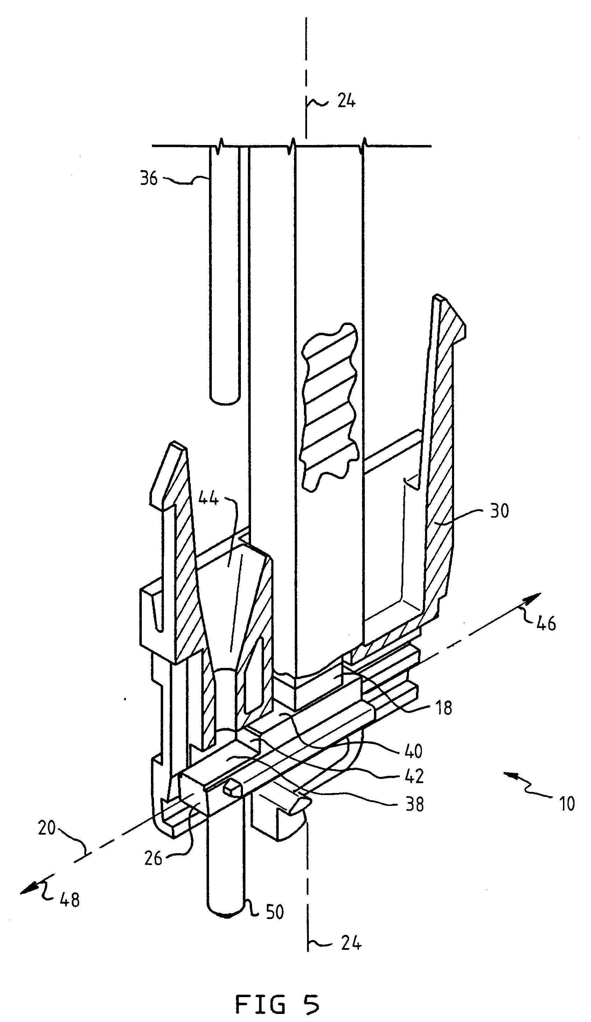

Overall operation of the apparatus will be generally described with reference to Figs. 5-9 and Fig. 13. This will be followed by more detailed description of the structure of the apparatus.

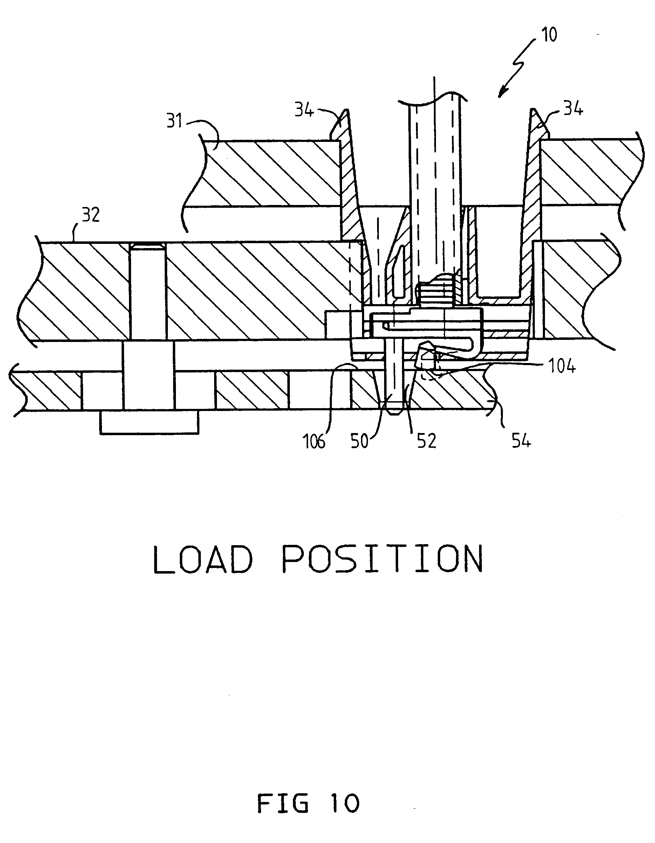

With brief reference first to Fig. 10 however, the apparatus 10 will preferably be positioned on a load plate 32 having a pair of connector means 34 for releasably supporting the apparatus 10 thereon. Whereas it is contemplated to provide a plurality of such apparatus 10 carried by various locations in the plane of the load plate 32 (corresponding to a plurality of correlative chip sites 14 also disposed horizontally on the plane of circuit board 16), only a singular apparatus 10 is shown for clarity.

Referring now to Fig. 5, apparatus 10 is depicted therein in a first operational position. Tube 36 is withdrawn to this position only during unloading. In this first state a vacuum tube 36 has been withdrawn upwards above a chamber means in the form of a vacuum tube aperture 44 extending downwards generally through the block 30, the purpose of the tube 36 and aperture 44 to be described hereinafter. Also in the first state of apparatus 1, after loading the slider 26 is moving along line 20 in the general direction of arrow 46. It will be noted that the first chip 18 of the stack is in a first position within the stack in vertical registry therewith.

With reference to the general description of Figs. 5-9, the slider 26 will be shuttled back and forth along line 20 in the direction of arrows 46 and 48. Although the mechanism whereby this is accomplished will be hereinafter described in greater detail, for present purposes it will be noted that the slider 26 is provided with a projection means 50 extending downwards. With reference to Fig. 10, this projection means 50 will preferably extend into an aperture 52 within a shuttle plate 54. Reciprocating movement of the shuttle plate 54 in the direction of arrows 46 and 48 will cause engagement of the shuttle plate 54 with the projection means 50 thereby causing correlative urging of the slider 26 along the line 20 in the desired manner.

Still referring to Fig. 5 yet an additional aspect of the slider 26 may be noted, namely that a plurality of surfaces hereinafter referred to as a first stripper surface 38, second stripper surface 40, and step surface 42 are disposed in the upper portion of the slider 26. In the first operating state of Fig. 5, the lower surface of the first chip 18 will ride on the second surface 40 during aforementioned movement of the slider 26 in the direction of arrow 46. In this manner, the stack of chips will be supported and maintained in a substantially constant vertical alignment along the longitudinal axis 24 of the stack during the movement of slider 26.

Referring now to Fig. 6, the apparatus 10 is shown in a second operational state. The vacuum tube 36 has been urged from the first position shown in Fig. 5 downwards to a second position disposed within the aperture 44. The conical shape of the surface 56 of block 30 defining the aperture 44 is for purposes of guiding the tube 36 into vertical alignment within the smaller cylindrically shaped second vacuum tube aperture 58. Also in this second operating state, the slider 26 has been urged by means of the aforementioned shuttle plate 54-projection means 50 combination sufficiently in the direction of arrowhead 46 so as to cause the first stripper surface 38 of slider 26 (better seen in Fig. 5) into a position in vertical registry with the stack and the longitudinal axis 24 thereof. During such movement the stack is caused to drop generally downwards in the direction along axis 24 until the lowermost first chip 18 is disposed with the lower surface thereof in engagement with the first stripper surface 38.

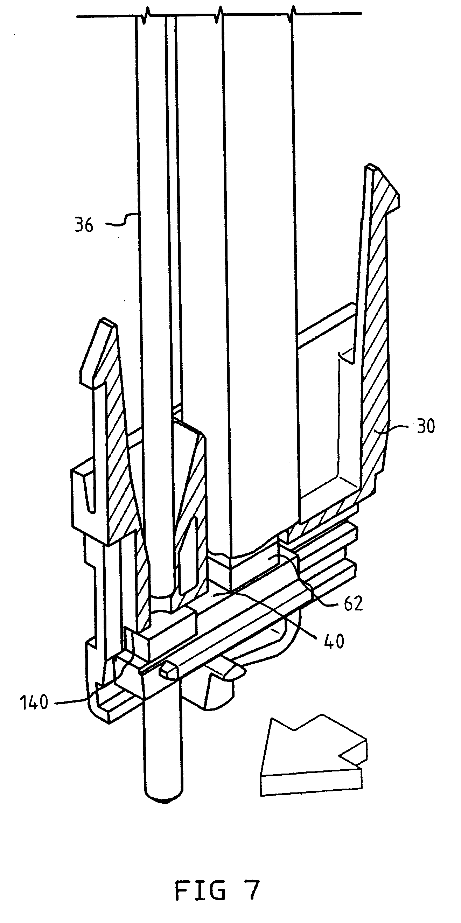

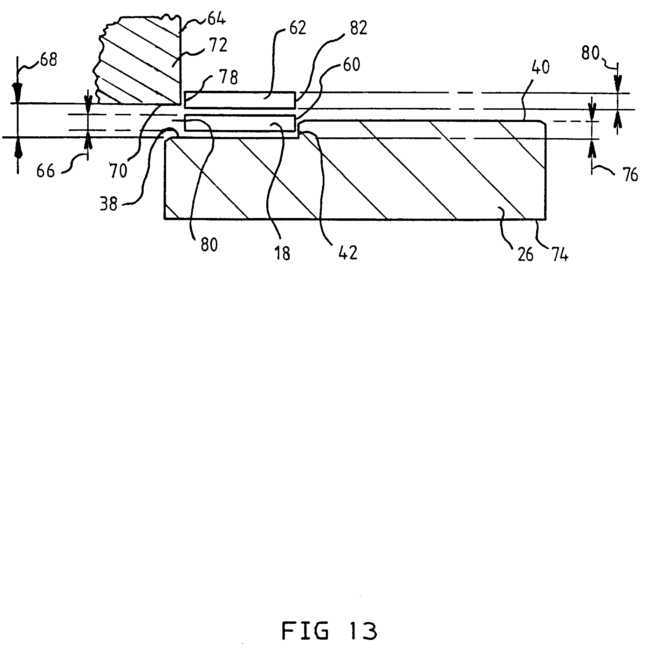

Referring now to Fig. 7, the apparatus 10 is depicted therein in yet a third operational state wherein the slider 26 has been urged by shuttle plate 54-projection means 50 from the first position shown in Fig. 6 along the line 20 to the second position shown in Fig. 7. With reference to Fig. 13 it will be noted that during such movement the step surface 42 engages the vertical edge 60 of the lowermost first component 18 of the stack stripping the component 18 from the stack and transporting it from its first position shown in Fig. 6 to its second position shown in Fig. 7 in vertical alignment with the vacuum tube 36, vacuum tube aperture, 44, and second vacuum tube aperture 58.

While the apparatus is moving into the third operational position of Fig. 7, a pressure difference is established vertically across the first chip 18. In one form, a vacuum is drawn on the tube 36 thereby lifting the first component 18 in a vertical direction until it abuts surface 140 of block 30, thereby retaining it in the position shown. It will also be noted that by stripping the lowermost first component 18 from the bottom of the stack, a second component 62 which was vertically adjacent and above the first component when disposed in the stack has been caused to be supported by the second stripper surface 40 while in sliding engagement with the lower surface of this second component as the slider 26 is moved from the first position of Fig. 6 to the second position of Fig. 7. This in turn causes vertical support of the stack during such movement whereby this second component 62 has, by means of removal of the lowermost first component 18, thereby been made to occupy the lowermost position in the stack vacated by the first chip.

With reference to Fig. 8, the apparatus 10 is depicted in yet a fourth operational state. In this state, the slider 26 has been urged, again by means of the projection means 50-shuttle plate 54 along line 20 in the direction of arrowhead 46 to the first position. Due to the aforementioned vacuum being drawn by the tube 36, the previously lowermost chip 18 of the stack is retained in the second position shown in Fig. 8. A comparison of Figs. 7 and 8 will indicate that the second component 62, as the slider 26 moves into the first position of Fig. 8 will be caused to slide off of the second stripper surface 40 down onto the first stripper surface 38.

Fig. 9 depicts the apparatus 10 in a fifth operational state. From a comparison with Fig. 8, it will be appreciated that the vacuum tube 36 has been urged in a generally downward direction along the longitudinal axis of the tube to a third position as shown in the figure. A slot 153 in the bottom of block 30 permits movement of the tube 36 and chip 12 therethrough so as to effect the operational states of Figs. 8 and 9. Due to the vacuum being drawn by the tube 36, the first component 12 is carried downward with the tube until it is pressed into the circuit board 16 at the desired corresponding site 14 at a third position of the chip 12. Upon pressing the chip 12 into the site 14 (which may have an adhesive material deposited thereon previously), the vacuum is discontinued and tube 36 is thence raised vertically to the first position shown in Fig. 5 whereupon the sequence of operations may be repeated after a next circuit board 16 is placed in registry beneath the apparatus 10.

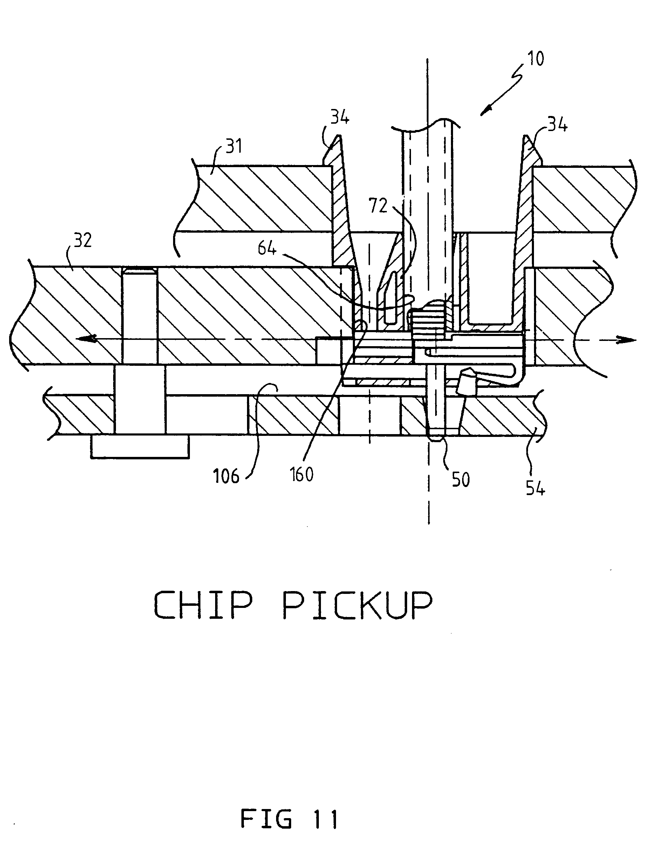

Important dimensional relations between the slider 26, first and second chips 18 and 62, respectively, and block 30 will now be noted. With reference to Fig. 11 and 13 the block 30 contains internally thereof a retainer means 72 for preventing movement of the second chip 62 in the direction of the transverse line 20 during the urging of the first chip 18 along the line by means of the slider 26. As may be seen from Fig. 13, the retainer face 64 of the retainer means 72 will matingly engage second chip face 78 during movement of the slider 26 to prevent the second chip 62 from being carried along with the first chip 18 by the slider 26. The first and second chips 18 and 62, respectively, will define a corresponding first chip thickness 66 and second chip thickness 80. A first distance 68 will further be defined by the distance between a lower surface 70 of the retainer means 72 and the upper first stripper surface 38 of the stripper 26 when in sliding engagement with the block 30. This first distance 68, as may be seen from Fig. 13, will preferably be selected in magnitude so as to be slightly larger than the magnitude of the first thickness 66 of the first component 18 and less than the sum of this first chip thickness 66 and the chip thickness 80 of the adjacent second component 62. If the first distance 68 was selected to be equal to or less than the first chip thickness 66, the first chip 18 could not thereby readily and reliably slide through the aperture 80 between the lower surface 70 of the retainer means 72 and the upper first stripper surface 38.

Conversely, if the first distance 68 was to equal or exceed the sum of the magnitudes of the first and second thicknesses 66 and 80 of corresponding first and second chips 18 and 62, the second chip 62 would not thereby be restrained from being carried by the slider 26 during urging of the first chip 18 along the line 20.

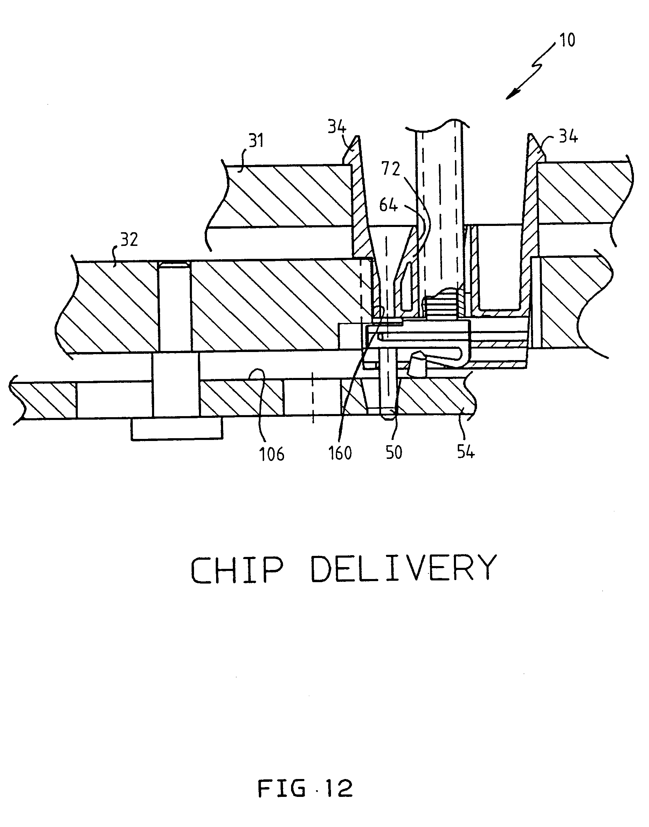

Referring to Fig. 11 a location surface 160 is provided in load plate 32. Machining in top plate 31, load plate 32, and shuttle plate 54 are with reference to common tooling pin reference points on all plates in a manner well known in the art so as to assure proper relative vertical positioning of the various components, apertures and the like herein described. Accordingly, for example, the location surface 160 is so machined very accurately relative to these tooling pin references. The surface 160 serves as a stop (see Fig. 12) whereby further movement leftward of the first chip 18 is prevented thereby accurately positioning the chip transversely in a desired location relative to tube 36 and site 14. In this manner tolerance problems are eliminated in seeking to stop chip movement by a component carried by block 30 which for example might be capable of moving laterally slightly while mounted in plate 32.

Referring again to Fig. 13, a second distance 76 is defined between the first and second stripper surfaces 38 and 40, respectively, which will preferably be slightly less in magnitude than the first chip thickness 66. If this second distance 76 equals or exceeds the first chip thickness 66, as the stripper 26 moves along line 20 stripping off the lowermost first chip 18 from the stack by means of the step surface 42 engaging the edge 60 of the first chip 18, this step surface 42 would also engage the edge 82 of the second component 62 thereby undesirably also urging it along the line 20.

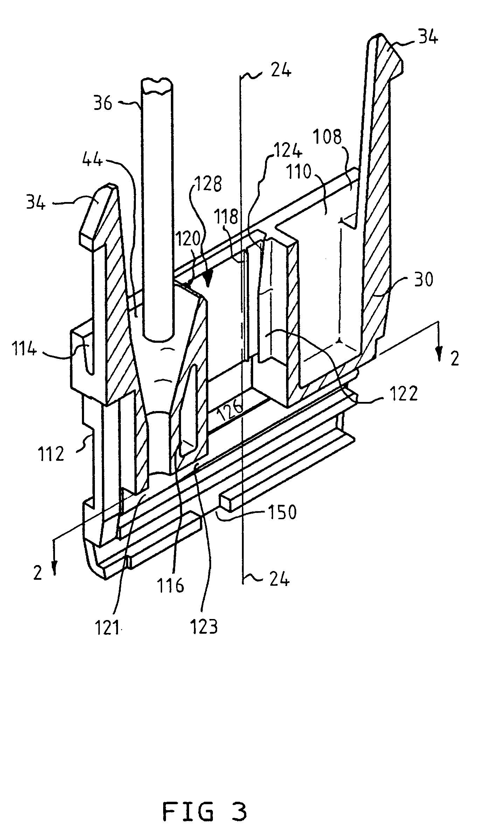

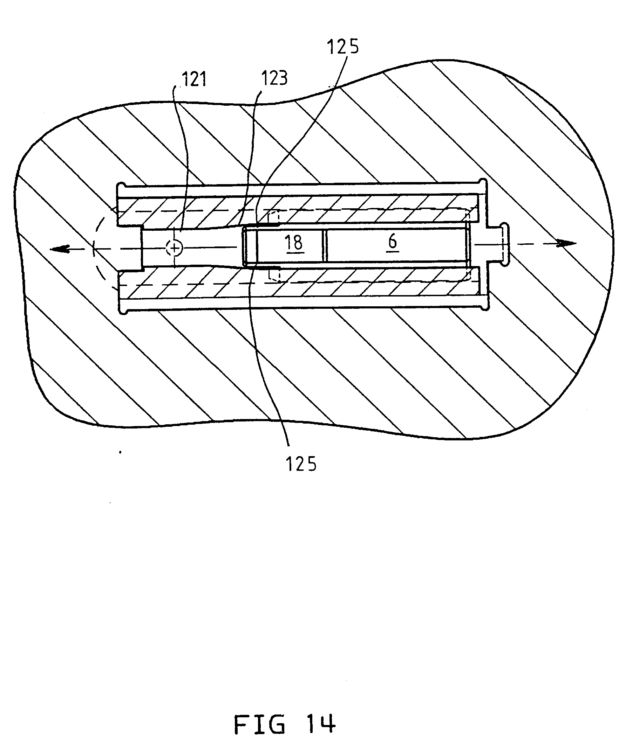

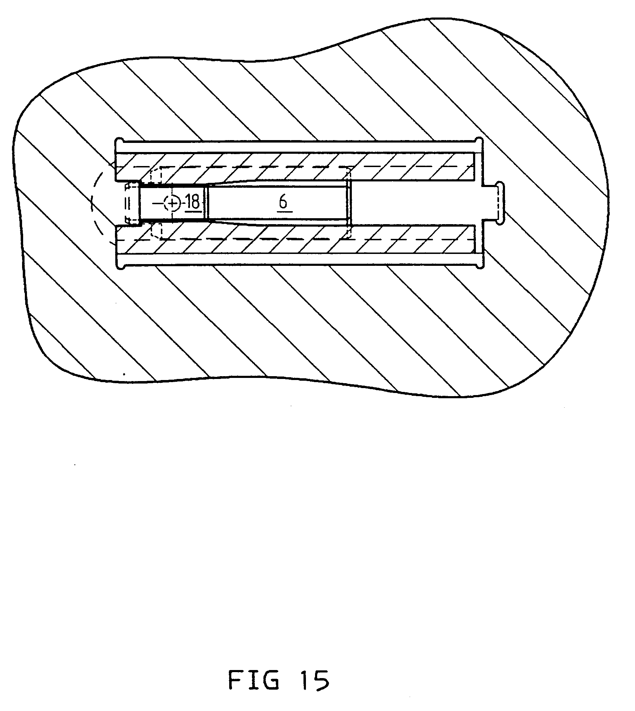

As shown in Figs. 3, 14, and 15, the block 30 is provided with opposing surfaces 121 parallel to line 20 and opposing surfaces 123 angulated away from line 20. The transverse distance between surfaces 123 is greater than chip 18 width and decreases with movement in the direction of arrow 48. Transverse distance between surfaces 121 is approximately the width of chip 18. Accordingly as the chip travels from the position of Fig. 14 to that of Fig. 15, the tapering surfaces 123 contacting leading edges 125 of chip 18 serve to guide or adjust orientation thereof relative to the line 20 during such movement to a final desired orientation. This is maintained by the surfaces 121 contacting the chip sides.

With reference to Fig. 2, the slider 26 will now be described in greater detail. First it will be noted that the slider 26 is preferably symmetrical about a vertical bifurcating plane including line 20 and vertical axis 24. This symmetry is also true with respect to the block 30. Accordingly, for simplicity, throughout this disclosure features of the slider 26 and block 30 may only be described with reference to portions thereof lying on one side of the aforementioned plane. Continuing, with Fig. 2, a pair of rails 84 are disposed on opposing sides of the slider 26, each rail having a rail side 86, rail top 88, rail bottom 89 and lead-in 90, the latter of which may take the form of a taper such as a truncated pyramid. The purpose of these rails 84 and in particular the bottom, side, and upper surfaces 89, 86 and 88, respectively, will become more apparent upon more detailed description of the mounting block 30 and in particular the cavity 28 therewithin. However, in general it will be noted that the aforementioned surfaces will matingly and slidingly engage with corresponding surfaces defining the cavity 28 so as to slidably retain the slider 26 therewithin and to regulate precise movement of the slider 26 along the line 20 within the block 30.

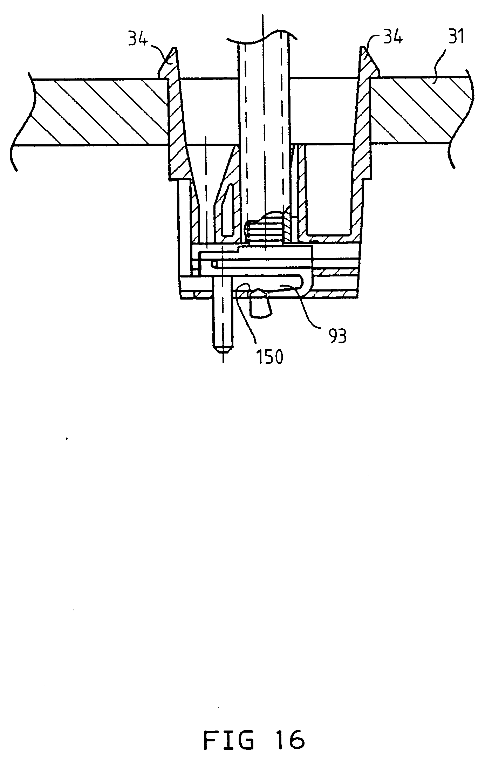

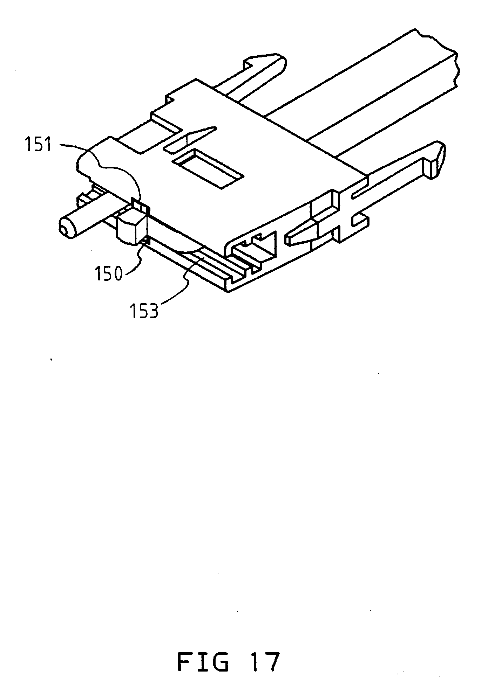

Still referring to Fig. 2, the slider 26 will also preferably be provided with a cantilevered spring 92 pendantly disposed from one end of the slider 26 opposite the end to which the projection means 50 is also pendantly disposed from the lower surface 74 of the slider 26. The purpose of this spring 92, as will also become more readily apparent with the following description, is basically to bias the slider 26 in an upwards direction for a close fit with the block 30 to take into account manufacturing tolerances in space necessary for assembly of the slider 26 within the block 30. This upward biasing, with reference to Fig. 10, may be seen to be caused by sliding engagement at contact point 104 with the upper surface 106 of the shuttle plate 54 during sliding of the slider 26 along with the shuttle plate 54 relative to the body 30. Yet an additional purpose of the spring 92 will be described in greater detail with reference to Figs. 10-12, but for present purposes is basically to provide a releasable locking mechanism whereby the slider 26 may be fixed in a releasably locked position with reference to the block 30 as shown in Fig. 16 and 17. In this manner, the apparatus 10 may be transported with the magazine 22 filled with a stack of components 12 to a location wherein one or more such apparatus will thence be mounted as in Fig. 10 with no concern that the slider 26 will inadvertently exit the cavity 28 of the block 30. Such slider movement during transportation would thereby cause the chip contents of the magazine 22 to undesirably fall from within the magazine 22 during such transport or storage prior to use.

During operation the lower surface 102 (Fig. 2) of the spring 92 rides on the upper surface 106 of the shuttle plate 54 (Figs. 10-12). As will hereinafter be detailed, at the end of the spring 92 distal to the point of interconnection of the spring 92 to the lower surface 74 of the slider 26, a wing shaped locking member 94 is provided having leading and trailing edges 96 and 98, respectively. Pendantly disposed intermediate the ends of the locking member 94 and downwards therefrom is a detent 100 portion having the aforementioned lower surface 102 which slidingly engages the shuttle plate upper surface 106. In the locked position, the wing-shaped projections of the locking member 94 on either side of the bifurcating plane will engage corresponding cavities 150, and 151 (Figs. 3, 4, 6, 17) so as to prevent the slider 26 from sliding along line 20 relative to the block 30 during transportation and non-use of apparatus 10. Due to the spring action of the spring 92, this distal end thereof including the detent 102 and locking member 94 may be moved vertically upwards and downwards. In this manner when it is desired to unlock the slider 26, as shown in the positions of Figs. 10, 11 and 12, the locking member 94 including the detent 100 may be moved upwards and outward from their mating cavities 150, 151 when in the locked position (Fig. 16) to the unlocked positions (Figs. 5-9), to permit desired movement of the slider 26 along line 20 during operation of the apparatus 10. During unlocked operation locking member 94 will travel within cavity 93, Fig. 16.

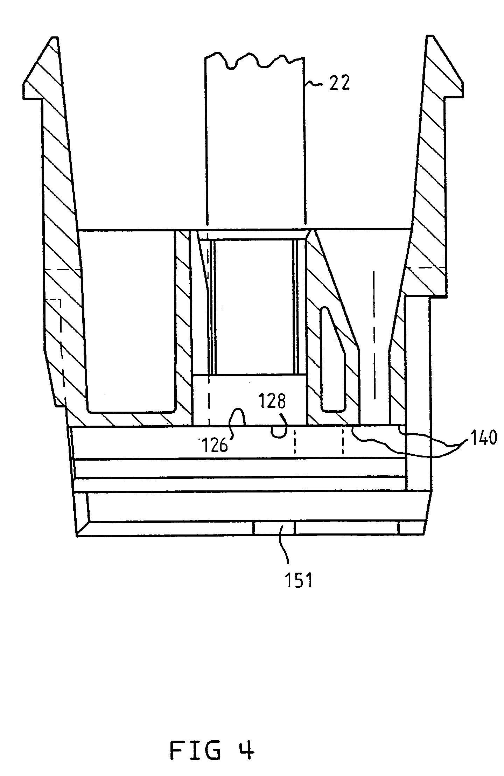

A more detailed description of the preferred construction of block 30 will now be given with reference to Figs. 3 and 4. First, it will be noted from Fig. 3 that a plurality of cavities 108, 110, 112, 114 and 116 are provided in the body of the block 30. The purpose of these cavities is primarily a practical consideration well known in the art of forming plastic components from a mold which is the preferred method of manufacture for the block 30. More particularly, these cavities provide for a more uniform wall thickness of many portions of the cavity thereby effecting a more uniform formation of the block 30 in the manufacturing process. With respect to cavities 108 and 114, however, yet an additional purpose thereof is to remove material from the base of the connector means 34 thereby permitting them to more readily flex to provide a press fit to the top plate 31 and to more readily releasably engage therefrom.

Still referring to Figs. 3 and 4, a particular feature of the walls defining the generally rectangular cavity 128 through which the longitudinal axis 24 extends will now be noted. Specifically, ridges 118 and 120 on opposing first faces of the walls will be provided the purpose of which is to provide deformable edges in sliding engagement with the magazine 22 as it is inserted into the cavity 128 so as to provide a tight interference fit, thereby retaining the magazine 22 securely within the cavity 128. A similar function is provided by a ridge 122 on another face also defining the cavity 128 extending perpendicularly to the first faces. With respect to this latter ridge 122, a guide portion 124 thereof is angulated inwards toward axis 24 thereby easing initial insertion of the magazine 22 while gradually providing an increased interference fit between the block 30 and magazine 22 as the latter is increasingly inserted within the cavity 128. A lower face 126 lying in a plane generally normal to the longitudinal axis 24 is provided which acts as a stop preventing further downward insertion of the magazine 22 within the cavity 128 by means of abutting engagement with the lowermost end of the magazine 22 as it is inserted within the cavity 128. The function of this face 126 may be more clearly seen with reference to Fig. 4 which shows the lower end 128 of the magazine 22 in abutting engagement therewith.

Whereas the embodiment of the invention depicted is adapted particularly well to surface mounted type leadless electronic components as well as orientation of the magazines generally normal to and above the circuit board for component placement on the upper surface thereof, the invention is not intended to be so limited.

Accordingly the invention may be adapted to positioning of various small components or articles of manufacture. Moreover the magazines need not be positioned normal to the board nor from a position thereabove. For example, in applications wherein it is desired to populate the underneath side of boards, the apparatus described herein may be inverted with minor modification such as the addition of means to continuously bias the chip stack upwardly.

## Claims

1. Manufacturing apparatus for positioning and mounting semiconductor chip circuit devices (12) at circuit board sites (14) comprising:
supporting means for supporting a stack of chips (12) adjacent a circuit board (16), defining a longitudinal axis (24) therethrough, and including a magazine (22) for receiving the stack of chips and a mounting block (30) carrying the magazine;
stripping means (26) for urging a first chip (18) from a first position adjacent to the stack along a line (20) substantially transverse to the stack into a cavity, and into a second position adjacent one of the circuit board sites (14); and
a vacuum tube (36) in which a pressure differential is created for supporting the first chip (18) against an end of the tube (36) while maintaining alignment with the circuit board site (14) by means of the cavity, characterised in that:
the cavity is defined by surfaces (121, 123, 140) of the mounting block (30); and
the stripping means (26) returns to the first position to accept a second chip (62) whilst the first chip (18) is supported by the tube (36).

2. Apparatus as claimed in Claim 1, further characterised in that:
the tube (36) with the first chip (18) supported thereon is moveable in a direction towards the circuit board (16) to position the first chip (18) at the circuit board site (14), the pressure differential being removed, and the tube being retracted, after such positioning has been effected.

3. Apparatus as claimed in claim 1 or claim 2, adapted to be releasably carried by a top plate (31), said mounting block (30) including connector means (34) for releasable interconnection of said block (30) to said top plate (31), wherein said stripper means (26) includes:
a first stripper surface (38) for carrying and maintaining the first chip (18) in a fixed orientation with respect to said line (20) while urging the first chip (18) from the first position to the second position; and
a second stripper surface (40) for restricting further chips from movement along said line (20) while urging the first chip (18) from the first to the second position.

4. Apparatus as claimed in claim 3 in which said stripping means (26) includes:
a step surface (42) intermediate said first (38) and second (40) stripper surfaces for engaging an edge (60) of said first chip (18) during movement of that chip (18);
surfaces (121, 123) for adjusting the orientation of the chip relative to said line (20) and
means (11) for urging said stack in the direction of said longitudinal axis (24) so as to move the second chip (62) into the first position.

5. Apparatus as claimed in claim 3 or claim 4 wherein:
said first (18) and second (62) chips define respective first (66) and second (80) thicknesses;
said first stripper surface (38) and a surface (70) of retainer means (72) define a first distance (68) therebetween; and
said first distance (68) is greater than said first thickness (66), but less than the sum of said first (66) and said second (80) thicknesses.

6. Apparatus as claimed in Claim 5 wherein said first stripper surface (38) and said second stripper surface (40) define a second distance (76) therebetween, said second distance (76) being less than said first thicknesses (66).

7. Apparatus as claimed in any preceding claim, wherein said stripping means (26) is in sliding engagement with said supporting means and includes a projection means (50) for limiting force transmitted from said stripping means (26) to said first chip (18).

8. Apparatus as claimed in any preceding claim, including chamber means (44) for maintaining said first chip (18) in said second position in response to a pneumatic pressure differential.

## Patentansprüche

1. Fertigungsgerät zum Positionieren und Aufsetzen von Halbleiter-Chip-Schaltkreisvorrichtungen (12) an Leiterplattenpositionen (14), bestehend aus:
Haltemitteln zum Halten eines Chip-Stapels (12) anliegend an eine Schaltkreisleiterplatte (16), die eine durch sie hindurchgehende Längsachse (24) definieren, einschließlich eines Magazins (22) zur Aufnahme des Chip-Stapels und eines Montageblocks (30), der das Magazin trägt;
Abstreifmitteln (26) zum Drücken eines ersten Chips (18) aus einer ersten Position am Stapel entlang einer Linie (20), die im wesentlichen quer zum Stapel verläuft, in einen Hohlraum und in eine zweite Position an einer der Leiterplattenstellen (14); und
einem Unterdruckrohr (36), in dem ein Druckunterschied erzeugt wird um den ersten Chip (18) an das Ende des Rohrs (36) zu befördern unter Beibehaltung der Ausrichtung mit der Leiterplattenstelle (14) mittels des Hohlraums, dadurch gekennzeichnet, daß
der Hohlraum definiert wird durch die Flächen (121, 123, 140) des Montageblocks (30); und
das Abstreifmittel (26) in seine erste Stellung zurückkehrt um einen zweiten Chip (62) aufzunehmen, während der erste Chip (18) von dem Rohr (36) gehalten wird.

2. Gerät gemäß Anspruch 1, weiter dadurch gekennzeichnet, daß
das Rohr (36) mit dem daran gehaltenen ersten Chip (18) in einer Richtung zur Leiterplatte (16) bewegbar ist, um den ersten Chip (18) an der Leiterplattenstelle (14) zu positionieren, dann der Druckunterschied aufgehoben wird und das Rohre zurückgezogen wird, nachdem die Positionierung ausgeführt wurde.

3. Gerät gemäß Anspruch 1 oder Anspruch 2, das so eingerichtet ist, daß es lösbar von einer oberen Platte (31) getragen wird, wobei der Montageblock (30) die Verbindermittel (34) zur lösbaren gegenseitigen Verbindung des Blocks (30) mit der oberen Platte (31) beinhaltet, wobei die Abstreifmittel (26) umfassen:
Eine erste Abstreiffläche (38) zum Tragen und Festhalten des ersten Chips (18) in einer festen Ausrichtung in Bezug auf die Linie (20), während der erste Chip (18) von der ersten Position in die zweite Position gedrückt wird; und
eine zweite Abstreiffläche (40), um weitere Chips in ihrer Bewegung entlang der Linie (20) zu beschränken während der erste Chip (18) aus der ersten in die zweite Position gedrückt wird.

4. Gerät gemäß Anspruch 3, in dem das Abstreifmittel (26) beinhaltet:
Eine Stufenfläche (42) zwischen der ersten (38) und zweiten (40) Abstreifflächen, die während der Bewegung des Chips (18) in eine Kante (60) des ersten Chips (18) eingreift;
Flächen (121, 123) zur Einstellung der Ausrichtung der Chips in Bezug auf die Linie (20) und
Mittel (11) zum Drücken des Stapels in Richtung der Längsachse (24), um den zweiten Chip (62) in die erste Position zu drücken.

5. Gerät gemäß Anspruch 3 oder Anspruch 4, bei dem:
Der erste (18) und der zweite (62) Chip entsprechend eine erste (66) und eine zweite (8) Dicke definieren;
die erste Abstreiffläche (38) und eine Fläche von Haltemitteln (72) einen ersten Abstand zwischen sich definieren; und
der erste Abstand (68) größer ist als die erste Dicke (66), jedoch weniger als die Summe der ersten (66) und der zweiten (80) Dicke beträgt.

6. Gerät gemäß Anspruch 5, wobei die erste Abstreiffläche (38) und die zweite Abstreiffläche (40) einen zweiten Abstand zwischen sich definieren, wobei der zweite Abstand (76) kleiner ist als die erste Dicke (66).

7. Gerät gemäß einem beliebigen der vorstehenden Ansprüche, bei dem das Abstreifmittel (26) in gleitendem Eingriff mit den Haltemitteln steht und ein vorspringendes Mittel (50) aufweist, um die von dem Abstreifmittel (26) auf den Chip (18) übertragene Kraft zu begrenzen.

8. Gerät gemäß einem beliebigen der vorstehenden Ansprüche, einschließlich eines Kammermittels (44) zum Halten des ersten Chips (18) in der zweiten Position als Reaktion auf einen pneumatischen Druckunterschied.

## Revendications

1. Appareil de fabrication pour le positionnement et le montage de dispositifs de circuits sur des microplaquettes semiconductrices (12) à des emplacements d'une carte de circuits (14) comprenant:
- un moyen de support d'une pile de microplaquettes (12) adjacente à une carte de circuits (16), définissant un axe longitudinal au travers de cette dernière, et comportant un chargeur (22) pour recevoir la pile de microplaquettes et une platine de montage (30) portant le chargeur,
- un moyen de retrait (26) pour solliciter une première microplaquette (18) d'une première position adjacente à la pile suivant une ligne (20) pratiquement transversale à la pile dans un creux et dans une seconde position adjacente à l'un des emplacements (14) de la carte de circuits, et
- un tube d'aspiration (36) dans lequel une pression différentielle est crée pour appliquer la première microplaquette (18) contre une extrémité du tube (36) tout en maintenant l'alignement avec l'emplacement de la carte de circuits (14) au moyen du creux,
caractérisé en ce que:
le creux est défini par des surfaces (121, 123, 140) de la platine de montage (30), et
le moyen de retrait (26) revient dans la première position pour accepter une seconde microplaquette (62) tandis que la première microplaquette (18) est retenue par le tube (36).

2. Appareil selon la revendication 1, caractérisé en outre, en ce que:
le tube (36) retenant la première microplaquette (18) est mobile dans une direction orientée vers la carte de circuits (16) pour positionner la première microplaquette (18) à l'emplacement de carte de circuits (14), la pression différentielle étant supprimée et le tube étant rétracté après que ce positionnement ait été effectué.

3. Appareil selon la revendication 1 ou la revendication 2 prévu pour être monté de manière amovible sur un plateau supérieur (31), ladite platine de montage (30) comprenant des moyens de connexion (34) pour la connexion et la déconnexion de ladite platine (30) et dudit plateau supérieur (31), dans lequel ledit moyen de retrait (26) comprend:
- une première surface de retrait (38) pour entraîner et maintenir la première microplaquette (18) dans une orientation fixe par rapport à ladite ligne (20) tout en sollicitant la première microplaquette (18) de la première position à la seconde position, et
- une seconde surface de retrait (40) pour empêcher le mouvement d'autres microplaquettes le long de ladite ligne (20) tout en sollicitant la première microplaquette (18) de la première à la seconde position.

4. Appareil selon la revendication 3 dans lequel ledit moyen de retrait (26) comprend:
- une marche (42) entre lesdites première (38) et seconde (40) surfaces de retrait pour solliciter un bord de ladite première microplaquette (18) pendant le mouvement de celle ci,
- des surfaces (121, 123) pour ajuster l'orientation de la microplaquette par rapport à ladite ligne (20) et
- des moyens (11) pour solliciter ladite pile dans la direction dudit axe longitudinal (24) de façon à amener la seconde microplaquette (62) à la première position.

5. Appareil selon la revendication 3 ou la revendication 4 dans lequel:
- ladite première (18) et ladite seconde (62) microplaquettes définissent des première (66) et seconde (80) épaisseurs, respectivement,
- ladite première surface de retrait (38) et une surface (70) du moyen de retenue (72) définissent une première distance (68) entre elles, et
- ladite première distance (68) est supérieure à ladite première épaisseur (66) mais inférieure à la somme desdites première (66) et seconde (80) épaisseurs.

6. Appareil selon la revendication 5 dans lequel ladite première surface de retrait (38) et ladite seconde surface de retrait (40) définissent une seconde distance (76) entre elles, ladite seconde distance (76) étant inférieure à ladite première épaisseur (66).

7. Appareil selon l'une quelconque des revendications précédentes dans lequel ledit moyen de retrait (26) est monté coulissant dans ledit moyen de support et comprend un moyen en projection (50) pour limiter la force transmise depuis ledit moyen de retrait (26) à ladite première microplaquette (18).

8. Appareil selon l'une quelconque des revendications précédentes, comprenant une chambre (44) pour maintenir ladite première microplaquette (18) dans ladite seconde position en réponse à une pression différentielle pneumatique.
